Europäisches Patentamt

European Patent Office

Office européen des brevets

(11) Publication number: **0 078 177**
**B1**

## (12) EUROPEAN PATENT SPECIFICATION

(45) Date of publication of patent specification: **15.10.86**

(51) Int. Cl.⁴: **H 01 S 3/19, H 01 L 33/00**

(21) Application number: **82305677.5**

(22) Date of filing: **26.10.82**

(54) Semiconductor light-emitting device.

(30) Priority: **27.10.81 JP 171801/81**

(43) Date of publication of application:
**04.05.83 Bulletin 83/18**

(45) Publication of the grant of the patent:
**15.10.86 Bulletin 86/42**

(84) Designated Contracting States:
**DE FR GB**

(56) References cited:
**US-A-3 812 516**

**APPLIED PHYSICS LETTERS, vol. 38, no. 11,
June 1981, pages 835-837, New York, USA,
W.T. TSANG: "A new current-injection
heterostructure laser: the double-barrier
double-heterostructure laser"**

**ELECTRONICS LETTERS, vol. 17, no. 6, 19th
March 1981, pages 226-227, Hitchin Herts, G.B.,
Y. NODA et al.: "High temperature CW
operation of 1.5 mum InGaAsP/InP buffer-layer
loaded planoconvex waveguide lasers"**

**IEEE ELECTRON DEVICE LETTERS, vol. EDL-2,
no. 9, September 1981, pages 234-236, New
York, USA, R. YEATS et al.: "Performance
characteristics and extended lifetime data for
InGaAsP/InP LED's"**

(73) Proprietor: **FUJITSU LIMITED
1015, Kamikodanaka Nakahara-ku
Kawasaki-shi Kanagawa 211 (JP)**

(72) Inventor: **Ishikawa, Hiroshi
Kopo K 101, 3-10-18, Todoroki
Setagaya-ku Tokyo 158 (JP)**
Inventor: **Yano, Mitsuhiro
Dai-3 Wataya-so 15-7, Shinjonakamachi
Nakahara-ku
Kawasaki-shi Kanagawa 211 (JP)**

(74) Representative: **Fane, Christopher Robin King
et al
HASELTINE LAKE & CO. Hazlitt House 28
Southampton Buildings Chancery Lane
London, WC2A 1AT (GB)**

(56) References cited:
**ELECTRONICS LETTERS, vol. 15, no. 21,
October 1979, pages 695-696, N.E. NAHORY et
al.: "Temperature dependence of InGaAsP
double-heterostructure laser characteristics"
(J.J. HSIEH)
(K. ITHOH, M. INOUE)
(B.W. HAKKI, C.J. HWANG)**

Courier Press, Leamington Spa, England.

## Description

The present invention relates to a semiconductor light-emitting device according to the prior art portion of claim 1.

Semiconductor light-emitting devices, such as double hetero-structure lasers or light-emitting diodes composed of GaAlAs, are readily available for commercial use.

In recent years, double hetero-structure lasers or light-emitting diodes composed of InGaAsP/InP, have also become available for commercial use, especially in the field of light communications systems. In InGaAsP/InP-type semiconductor light-emitting device (laser), emits a light having a wavelength in the range of $1 \sim 1.6$ µm, which is better suited for light communications systems as regards transmission loss along an optical fibre used with the device, as compared with light emitted from the widely used GaAlAs-type laser having a wavelength of 0.85 µm.

Although a known InGaAsP/InP-type laser is preferable for a light communications system, it has a defect in respect to the so-called lasing threshold level-temperature characteristic. In general, the lasing threshold level should be relatively constant with respect to a wide range of ambient temperatures. In this regard, the known InGaAsP/InP-type laser does not have a good characteristic; that is, the lasing threshold level sharply increases with an increase of temperature, especially when the temperature is over about 70°C.

The reason for the above-mentioned defect resides briefly in a so-called "carrier leakage"; that is, carriers pass over a hetero-barrier and run away therefrom, since electron energies are distributed, in an active layer, at higher levels with the increase of temperature. As a result some of the electrons having a sufficient energy level to go over the hetero-barrier leak into a clad layer. It is considered that consequent wide variations of the lasing threshold level with respect to the temperature may be increased by a relatively long energy relaxation time of electrons in an active layer and also by Auger processes, in which an electron attains high energy through non-radiative combination of neighbouring electrons. These mechanisms increase the number of electrons having a sufficient energy to go over the hetero-barrier.

It is desirable to overcome or at least reduce the above-mentioned defect of an InGaAsP/InP-type double hetero-structure laser. The invention as claimed in claim 1 is intended to remedy these drawbacks. The invention provides a semiconductor buffer layer sandwiched between the active layer and a clad layer of such a device, the buffer layer being on the side of the active layer upstream of the direction of electron flow and being of the opposite conductivity type to the adjacent clad layer. This construction is thus to be distinguished from the InGaAsP/InP laser diode disclosed by Y. Noda et al. In "Electronics Letters", 19th March 1981, vol. 17, No. 6, pages 226-227, in which an n-type InGaAsP layer is sandwiched between the InGaAsP active layer and the n-type InP clad layer to act as a waveguide, and an InGaAsP buffer layer is sandwiched between the active layer and the p-type InP clad layer.

Reference will now be made, by way of example, to the accompanying drawings, in which:

Figure 1A is a cross-sectional view of a conventional semiconductor laser;

Figure 1B is an energy band diagram for the semiconductor laser of Fig. 1A;

Figure 2A is a cross-sectional view of a semiconductor laser according to a first embodiment of the present invention;

Figure 2B is an energy band diagram for the semiconductor laser of Fig. 2A;

Figure 2C is an energy band diagram for the semiconductor laser of Fig. 2A;

Figure 3 is a cross-sectional view of a semiconductor laser according to a second embodiment of the present invention;

Figure 4 is a graph; and

Figure 5 is a cross-sectional view of an example of a laser to which an embodiment of the present invention may be adapted.

Figure 1A is a cross-sectional view of a conventional semiconductor laser. In Fig. 1A, reference numeral 1 represents an electrode made of an alloy of, for example, Au·Ge·Ni. On the electrode 1, an n type InP substrate (first clad layer) 2 is formed. On the clad layer 2, a p type InGaAsP active layer 3 is formed. On the active layer 3, a p type InP layer (second clad layer) 4 is formed. On the clad layer 4, an n type InGaAsP (current-restriction) layer 5 is formed. A p type current path region 6 is formed from the top surface of the current-restriction layer 5 and extends to the second clad layer 4. On the layer 5, an electrode 7 made of an alloy of, for example, Au·Zn, is formed.

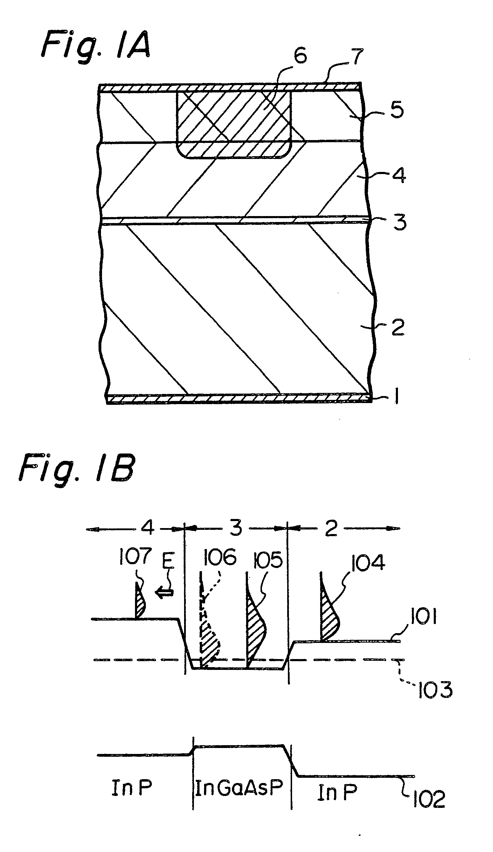

Figure 1B depicts energy bands along the layer 2, 3, and 4 of Fig. 1A under a forward bias of the semiconductor laser. In Fig. 1B, reference numeral 101 denotes a conduction band, 102 a valence band, and 103 the Fermi level with respect to the electrons. The energy bands at the first clad layer 2, the active layer 3, and the second clad layer 2, the active layer 3, and the second clad layer 4 are schematically illustrated in Fig. 1B by reference numerals 2, 3, and 4. In Fig. 1B, the curved hatchings represent the distribution of electrons; that is, the ordinate (vertical direction) indicates the energy while the abscissa (horizontal direction) indicates the number of electrons.

In the conventional semiconductor laser, when electrons having a distribution curve 104 during their presence in the first clad layer 2 are injected into the active layer 3, since the energy relaxation time of the electrons in the InGaAsP active layer 3 is relatively long, the electrons having a high energy level, as shown by a distribution curve 105, cannot quickly be transformed into a thermal equilibrium state. The Auger process also prevents the electron distribution going into a thermal equilibrium, because electrons are excited to higher energy states in the conduction band in this process. The distribution curve 106 corresponds to a thermal equilibrium state.

The electrons which have a high energy level and fail to be transformed into a thermal equilibrium state pass through the hetero-barrier and leak into the second clad layer 4 in the direction of the arrow E. If the ambient temperature around the semiconductor laser is relatively high, the level of maximum occupation in the distribution curve 105 is shifted upward. Accordingly, the higher the ambient temperature, the larger the amount of electrons which leak into the clad layer 4 in the direction of the arrow E, as shown by a distribution curve 107. Thus, the lasing threshold level varies, although it should be constant, with the variation of ambient temperature. That is, the lasing threshold level is largely dependent on the ambient temperature.

In an embodiment of the invention, the above-mentioned leak of electrons can be suppressed in such a manner that the distribution curve of the electrons is reshaped so that it is almost identical to the curve 106, representing a thermal equilibrium state, before the electrons are injected into the active layer. Thereby, the dependency of the lasing threshold level on the ambient temperature can be minimized.

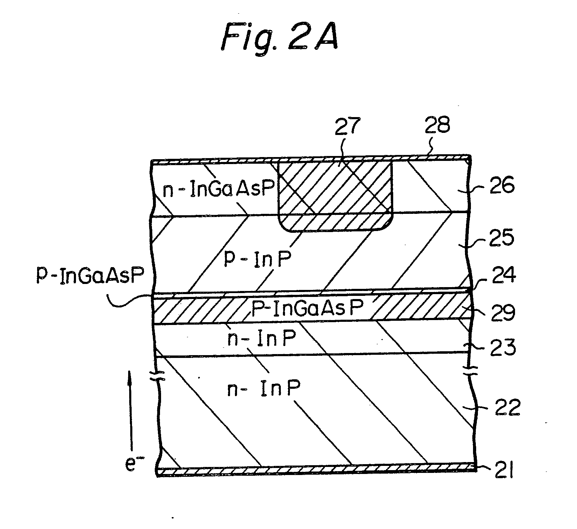

Figure 2A is a cross-sectional view of a semiconductor laser according to a first embodiment of the present invention.

In Fig. 2A, reference numeral 21 denotes an n side electrode made of Au·Ge·Ni, 22 an n type InP substrate having a thickness of about 150 μm, 23 an n type InP clad layer having a thickness of 3 μm, 24 an active layer of p type InGaAsP $(In_{1-x}Ga_xAs_{1-y}P_y$, x =0.3, y = 0.35) having a thickness of 0.1 ~ 0.2 μm, 25 a p type InP clad layer having a thickness of 1.5 ~ 2 μm, 26 an n type InGaAsP current-restriction layer having a thickness of 0.5 μm, 27 a p type current path region and 28 a p side electrode made of Au·Zn.

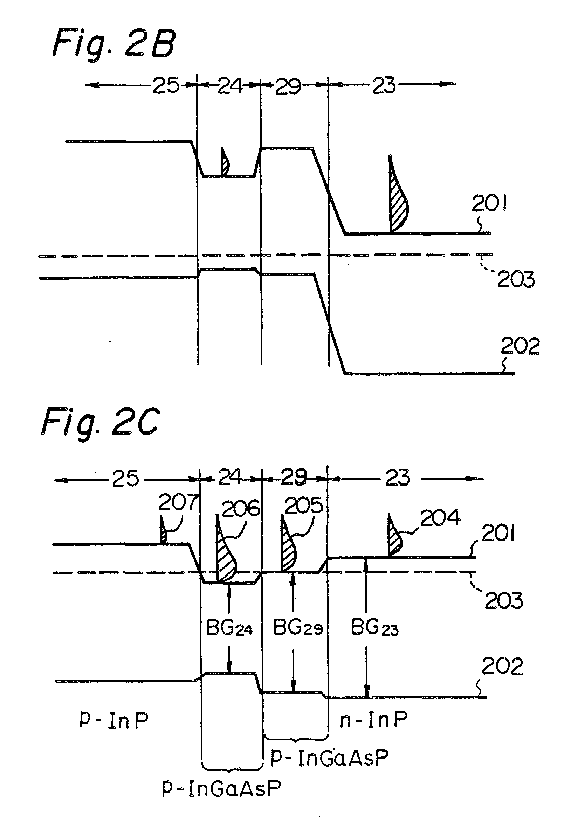

In Fig. 2A, a member 29 is newly introduced into the semiconductor laser, which is a p type InGaAsP semiconductor layer $(In_{1-x}Ga_xAs_{1-y}P_y$, x =0.13, y = 0.72) sandwiched between the first clad layer 24 of n type InP and the active layer 24 of P type InGaAsP. The band gap $BG_{29}$ of the semiconductor buffer layer 29 of p type InGaAsP is wider than the band gap $BG_{24}$ of the active layer 24 but is narrower than the band gap $BG_{23}$ of the first clad layer 23, that is $BG_{24} < BG_{29} < BG_{23}$ (refer to Fig. 2C).

The wavelength λ, corresponding to each band gap, is, for example, $\lambda_{24}$ = 1.3 μm for the $BG_{24}$, $\lambda_2$ = 0.94 μm for the $BG_{23}$, and $\lambda_{29}$ = 1.05 μm for the $BG_{29}$.

It is very important to note that the wider the band gap, the shorter the previously mentioned energy relaxation time and the smaller the probability of Auger processes. Accordingly, the energy relaxation time in the semiconductor buffer layer 29 is shorter than that of the active layer 24 and the probability of Auger processes in buffer layer 29 is smaller than that in the active layer 24. This means that during their passage across the buffer layer 29, most of the electrons are quickly transformed into a state which is close to the thermal equilibrium state prior to being injected into the active layer 24.

Further, it should be noted that the buffer layer 29 is located at the upper course of the flow of electrons with respect to the active layer 24 (the flow of electrons is schematically shown by the arrow e⁻ in Fig. 2A). In addition, the type of conductivity of the buffer layer 229 is opposite to that of the clad layer 23, which is located at the upper course of the flow of electrons seen from the buffer layer 29. Therefore, a p—n junction is formed between the clad layer 23 and the buffer layer 29.

Furthermore, since the electrons penetrate into the layer 29 by diffusion, the thickness of the buffer layer 29 must not exceed the diffusion length of the electrons injected into it. Accordingly, the thickness of the buffer layer 29 is determined to be, for example, 0.4 μm.

Figure 2B depicts an energy band along the layers 23, 29, 24, and 25 shown in Fig. 2A under a non-forward bias of the semiconductor laser. Figure 2C depicts an energy band along the layers 23, 29, 24, and 25 shown in Fig. 2A under a forward bias of the semiconductor laser. As is apparent from Fig. 2C, the energy level of the electrons, represented by a distribution curve 204, is lowered, as a whole, during the passage of the electrons across the buffer layer 29, with the result that a distribution curve 205 is obtained. Therefore, the energy level of the electrons is lowered in advance before the electrons are injected into the active layer 24 because, as previously explained, the $BG_{29}$ is wider than the $BG_{24}$. This means that the electrons are nearly in a state of thermal equilibrium prior to their injection into the active layer 24. Consequently, the amount of electrons which may leak from the active layer 24 into the second clad layer 25 is considerably reduced, as shown by distribution curve 207. In Fig. 2B, 201 represents a conduction band and 202 represents a Fermi level.

In the above embodiment, the band gap of the buffer layer 29 is narrower than that of the second clad layer 25, as shown in Fig. 2C. Thus, the hetero-barrier against holes is reduced. However, it should be understood that a hole leakage due to such a reduction of the hetero-barrier against holes is considerably small. This is because of the fact that the effective mass of the holes is larger than that of the electrons.

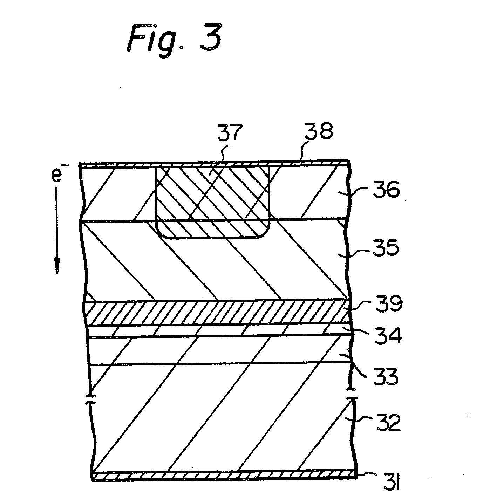

Figure 3 is a cross-sectional view of a semiconductor laser according to a second embodiment of the present invention. In Fig. 3, reference numeral 31 denotes a p side electrode, 32 a p type InP substrate, 33 a p type InP clad layer, 34 a p type InGaAsP active layer, 35 an n type InP clad layer, 36 a P type InGaAsP current-restriction layer, 37 an n type current path region and 38 an n side electrode. Reference numeral 39 denotes a buffer layer of p type InGaAsP.

The band gap $BG_{35}$ of the layer 35 must satisfy the equation $BG_{34} < BG_{39} < BG_{35}$. Further, the buffer layer 39 is located at the upper course of the flow of electrons seen from the active layer 34 (the flow of electrons is schematically shown the arrow $e^-$ in Fig. 3). In addition, the type of conductivity of the buffer layer 39 is opposite to that of the clad layer 35, which is located at the upper course of the flow of electrons seen from the the buffer layer 39.

Furthermore, since the electrons penetrate into the buffer layer 39 by diffusion, the thickness of the buffer layer 39 must not exceed the diffusion length of the electrons injected into it.

It will be apparent that embodiments of the present invention include a semiconductor buffer layer (29 or 39) sandwiched between the active layer (24 or 34) and a clad layer (23 or 35). A structure that might at first seem similar to this is disclosed in Japanese Examined Patent Publication (Kokoku) No. 57(1982)-33875, claiming a convention priority of U.S.S.N. 418,572 (and now matured as US—A—3,838,359), which also refers to a double hetero-structure laser. However, that publication refers to a GaAlAs-type semiconductor laser, and not a InGaAsP/InP-type semiconductor laser, and whereas the buffer layer in the present invention serves to improve the lasing threshold level-temperature characteristic, the apparently corresponding layer in the Japanese publication (referenced by 16 in Figure 1 of that publication) functions merely as a lossy region intended to prevent a gain region (active layer) from being damaged owing to the concentration optical field to the gain region. In this regard, the Japanese publication is concerned basically with a refractive index as $\delta_n$, which parameter has no such fundamental relevance to the present invention. In particular, the type of conductivity of the said lossy region (16) is the same as that of the adjacent layer (14), whereas in the present invention, the type of conductivity of the buffer layer is opposite to that of the adjacent clad layer.

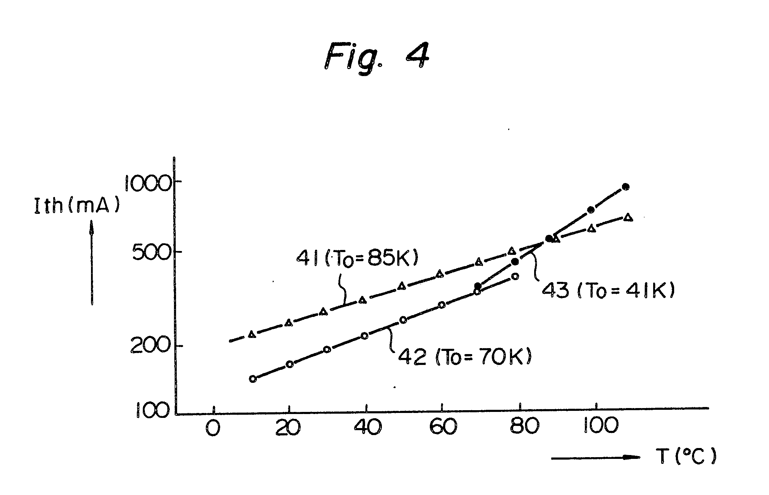

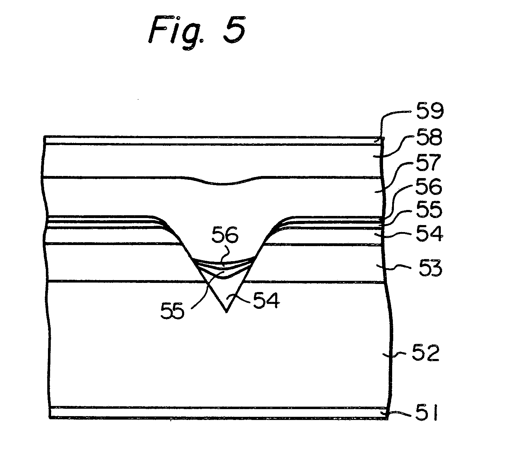

Figure 4 is a graph showing experimental data concerning the lasing threshold level with respect to atmospheric temperature. The ordinate indicates the lasing threshold level as a threshold current $I_{th}$ in mA and the abscissa indicates the atmospheric temperature in °C. Generally, the expression

$$I_{th} \propto I_0 \exp (T/T_0)$$

is known, where $I_0$ denotes the constant, T the temperature, and $T_0$ the parameter measured in an absolute temperature (K) and characterizes a temperature characteristic of the semiconductor laser. Specifically, the larger the $T_0$, the smaller the dependency of the threshold current $I_{th}$ on the temperature. Therefore, it is desirable to realize a semiconductor laser having a high $T_0$. In the graph of Fig. 4, a curve 41 indicates a characteristic of a semiconductor laser, embodying the present invention, as shown in Fig. 5. The value $T_0$ derived from the curve 41 is about 85K while the value $T_0$ derived from curves 42 and 43 is 70K and 41K, respectively, which curves are obtained by using conventional InGaAsP/InP-type semiconductor lasers each having a structure similar to that shown in Fig. 5 except having no buffer layer.

Figure 5 is a cross-sectional view of an example of a laser embodying the present invention. The use of a buffer layer can be adapted to various types of known double hetero-structure lasers. The structure shown in Fig. 5 is merely one example among many. Figure 5 shows a V-grooved substrate buried hetero-structure InGaAsP/InP laser. Reference numeral 51 represents an n electrode. An n type InP substrate 52 is located thereon. A current-choking layer 53 of p type Inp is formed thereon. Reference numeral 54 represents an n type InP clad layer. Reference numeral 56 represents an active layer of InGaAsP. A buffer layer as required by the present invention is constituted by a buffer layer 55 of p type InGaAsP. Reference numeral 57 represents a p type InP clad layer, 58 represents a p type InGaAs cap layer, and 59 represents a p electrode.

As previously mentioned, the energy relaxation of an electron is accelerated by the buffer layer in such a structure and thereby the electrons injected into the active layer are quickly transformed into a thermal equilibrium state. Thus, the buffer layer can improve the temperature characteristic.

The buffer layer can also contribute to an improvement in the following way.

With reference to Fig. 1B, excited electrons due to Auger processes leak into the clad layer 4 and run toward the clad layer 2. Accordingly, the Auger process contributes to worsening of the temperature characteristic. However, in embodiments of the invention, the Auger process is seemingly somewhat suppressed due to the presence of the buffer layer. That is, when some of the excited electrons, due to the Auger process, run into the buffer layer, the energy level of the excited electrons can easily be lowered because, as previously explained, the energy relaxation time defined in the buffer layer is shorter than that defined in the active layer.

As explained above in detail, an InGaAsP/InP-type laser can be made, in accordance with the present invention, such that its lasing threshold level is more constant with variations in ambient temperature, than is that of a conventional semiconductor laser. If desired, the laser according to the invention may also include a buffer layer contributing to the achievement of thermal equilibrium on the lower course of the flow of electrons, that is on the other side (downstream) of the active layer, in addition to the buffer layer on the upper course (upstream) of the flow.

Thus there can advantageously be provided a semiconductor light emitting device fabricated as a double hetero-structure laser composed of an InGaAsP/InP-type laser comprising at least an active layer and two clad layers between which said active layer is sandwiched, the type of conductivity of one of said two clad layers being opposite to that of the other clad layer, in which device a buffer layer made of a semiconductor is further introduced; said buffer layer being located at the upper course of the flow of electrons seen from said active layer; the type of conductivity of said buffer layer being opposite to that of the clad layer located at the upper course of the flow of electrons seen from said buffer layer; the band gap of said buffer layer being wider than that of said active layer but narrower than that of said clad layer adjacent to said buffer layer; and the thickness of said buffer layer being not greater than the diffusion length of the electrons injected into the buffer layer.

## Claims

1. A semiconductor light-emitting device, of the double hetero-structure laser type includding an InGaAsP active layer (24) between first and second InP clad layers (23, 25), the first clad layer (23) being of n-type conductivity and the second clad layer (25) being of p-type, characterized in that the device further includes a buffer layer (29) of p-type conductivity sandwiched between the said active layer (24) and the said first clad layer (23), the band gap of the said buffer layer being wider than that of the said active layer but narrower than that of the said first clad layer, and the thickness of the said buffer layer being no greater than the diffusion length of electrons injected into that layer from the said first clad layer under normal operating conditions of the device.

2. A device as claimed in claim 1, wherein the said active layer and the said buffer layer are composed of p-type InGaAsP.

3. A device as claimed in claim 1 or 2, further including a current-restriction layer (26) formed on one of the said first and second clad layers and having a current path region (27) extending therethrough to that one clad layer.

4. A device as claimed in any preceding claim, wherein the said active layer, the said buffer layer, and the said first and second clad layers are formed in a V-shaped groove buried in a semiconductor substrate.

## Patentansprüche

1. Lichtemittierendes Halbleiterbauelement, vom Laser-typ mit doppelter Heterostrucktur, mit einer aktiven InGaAsP-Schicht (24) zwischen einer ersten und einer zweiten InP-Ausgekleidungsschicht (23, 25), wobei die erste Auskleidungsschicht (23) vom n-Leitfähigkeitstyp und die zweite Ausleidungsschicht (25) vom p-Leitfähigkeitstyp ist, dadurch gekennzeichnet, daß die Vorrichtung ferner eine Pufferschicht (29) vom p-Leitfähigkeitstyp umfaßt, die schichtartig zwischen der genannten aktiven Schicht (24) und der genannten ersten Auskleidungsschicht (23) angeordnet ist, wobei der Bandabstand der genannten Pufferschicht breiter als derjenige der genannten aktiven Schicht, jedoch schmaler als derjenige der genannten ersten Auskleidungsschicht ist, und die Dicke der genannten Pufferschicht nicht größer als die Diffusionslänge von in diese Schicht von der genannten ersten Auskleidungsschicht unter normalen Betriebsbedingungen der Vorrichtung injizierten Elektronen ist.

2. Vorrichtung nach Anspruch 1, bei welcher die genannte aktive Schicht und die genannte Pufferschicht aus InGaAsP vom p-Typ zusammengesetzt sind.

3. Vorrichtung nach Anspruch 1 oder 2, ferner mit einer Strombegrenzungsschicht (26), die auf einer der ersten oder zweiten Auskleidungsschichten gebildet ist und einen Stromwegbereich (27) hat, der sich durch sie zu der einen Auskleidungsschicht hindurcherstreckt.

4. Vorrichtung nach einem der vorhergehenden Ansprüche, bei welcher die genannte aktive Schicht, die genannte Pufferschicht und die genannten ersten und zweiten Auskleidungsschichten in einer V-förmigen Nut gebildet sind, die in einem Halbleitersubstrat begraben ist.

## Revendications

1. Dispositif d'émission de lumière à semiconducteurs du type d'un laser à double hétérostructure comportant une couche active de InGaAsP (24) entre une première et une seconde couche de revêtement de InP (23, 25), la première couche de revêtement (23) étant de conductivité de type N et la seconde couche de revêtement (25) étant du type P, caractérisé en ce que le dispositif comporte en outre une couche tampon (29) de conductivité du type P intercalée entre ladite couche active (24) et ladite première couche de revêtement (23), l'intervalle de bande de ladite couche tampon étant plus large que celui de ladite couche active mais plus étroit que celui de ladite première couche de revêtement, et l'épaisseur de ladite couche tampon n'étant pas supérieure à la longueur de diffusion des électrons injectés dans cette couche depuis ladite première couche de revêtement dans des conditions normales de fonctionnement du dispositif.

2. Dispositif selon la revendication 1, dans lequel ladite couche active et ladite couche tampon sont faites de InGaAsP de type P.

3. Dispositif selon la revendication 1 ou 2, comportant en outre une couche de restriction de courant (26) formée sur l'une de ladite première et ladite seconde couche de revêtement et comprenant une région de trajet de courant (27) qui la traverse jusqu'a cette couche de revêtement.

4. Dispositif selon l'une quelconque des revendications précédentes, dans lequel ladite couche active, ladite couche tampon et ladite première et ladite seconde couche de revêtement sont formées dans une rainure en forme de V encastrée dans un substrat semi-conducteur.

*Fig. IA*

*Fig. IB*

0 078 177

*Fig. 2A*

2

*Fig. 2B*

*Fig. 2C*

# Fig. 3

Fig. 4

## Fig. 5